# EUROPEAN PATENT APPLICATION

(11) **EP 4 369 400 A1**
(43) Date of publication of application: **15.05.2024**
(21) Application number: 21854735.4
(22) Date of filing: 23.07.2021
(51) Int. Cl.: H01L 27/00

(54) **DISPLAY PANEL**

(30) Priority: 08.07.2021 CN 202110771752
(71) Applicant: Wuhan China Star Optoelectronics Semiconductor Display Technology Co., Ltd., Wuhan, Hubei 430079 (CN)
(72) Inventor: ZHANG, Shenfu, Wuhan, Hubei 430079 (CN)
(74) Representative: Murgitroyd & Company
(86) International application number: PCT/CN2021/108285
(87) International publication number: WO 2023/279450

(57) **Abstract**

The present disclosure discloses a display panel; the display panel includes a plurality of light-emitting repeating units, each of the light-emitting repeating units comprises: a plurality of first sub-pixels disposed close to a center point of a dummy rectangle; a plurality of second sub-pixels disposed close to vertices of the dummy rectangle; and a plurality of third sub-pixels disposed between the first sub-pixels and the second sub-pixels which are adjacent to each other, wherein a first light-emitting layer of the first sub-pixels overlaps with at least two of first electrodes of the first sub-pixels.

## Description

### FIELD OF INVENTION

The present disclosure relates to a display technology field, specifically to a display panel.

### BACKGROUND OF INVENTION

An organic light-emitting diode display (OLED) is a device that generates electroluminescence by using a multilayer structure of organic thin films. It not only has a simple manufacturing process, but also has a low driving voltage. These features make advantages of OLEDs in flat display technology very prominent. In addition, compared with a liquid crystal display (LCD), the OLED also has characteristics of compactness, high brightness, low power consumption, fast response times, high definition, good flexibility, and high luminous efficiency, which can meet new demands of consumers for display technology. Therefore, OLED displays have become a focus of development for major display manufacturers.

A pixel structure of an OLED display has a prominent influence on its display effect. The pixel structure of real sub-pixel means that each pixel unit includes a red sub-pixel (R), a green sub-pixel (G), and a blue sub-pixel (B) that are independent of each other. A mask used during the manufacturing process of this pixel structure has a relatively low aperture ratio, and it is difficult to meet current display requirements for a high pixel density. The pixel structure of combined sub-pixel is to combine the red sub-pixel (R) and the green sub-pixel (G), and the green sub-pixel (G) and the blue sub-pixel (B) to form a pixel unit. Although this pixel structure can improve the aperture ratio of the mask, its display effect is poor.

### SUMMARY OF INVENTION

### Technical Problem

At present, there is a technical problem in the pixel structure of the real sub-pixel that the mask used during the manufacturing process of the pixel structure of the real sub-pixel has a low aperture ratio.

### Technical Solution

The present disclosure provides a display panel to mitigate the technical problem of the low aperture ratio of the mask used during the manufacturing process of the pixel structure of the real sub-pixel.

The present disclosure provides a display panel, comprising: a plurality of first sub-pixels displaying a first color, wherein the first sub-pixel comprises a first electrode and a first light-emitting layer disposed on the first electrode;
a plurality of second sub-pixels displaying a second color, wherein the second sub-pixel comprises a second electrode and a second light-emitting layer disposed on the second electrode; and
a plurality of third sub-pixels displaying a third color, wherein the third sub-pixel comprises a third electrode and a third light-emitting layer disposed on the third electrode,
the display panel further comprises a plurality of light-emitting repeating units, each of the plurality of light-emitting repeating units comprises:
multiple first sub-pixels disposed close to a center point of a dummy rectangle, wherein the first light-emitting layer overlaps with at least two of the first electrodes;
multiple second sub-pixels disposed inside a region of the dummy rectangle and close to vertices of the dummy rectangle; and
multiple third sub-pixels disposed between the first sub-pixels and the second sub-pixels which are adjacent to each other, and overlapping with lines connecting the center point and the vertices of the dummy rectangle, and
an area of the first sub-pixel and an area of the second sub-pixel are both less than an area of the third sub-pixel.

In the display panel of the present disclosure, each of the light-emitting repeating units comprises a plurality of pixel units, each of the plurality of pixel units comprises one first sub-pixel, one second sub-pixel and one third sub-pixel.

In the display panel of the present disclosure, in each of the light-emitting repeating units, a minimum distance between the first sub-pixel and the third sub-pixel remains unchanged, and
a minimum distance between the second sub-pixel and the third sub-pixel remains unchanged.

In the display panel of the present disclosure, in each of the pixel units, the minimum distance between the first sub-pixel and the third sub-pixel is equal to the minimum distance between the second sub-pixel and the third sub-pixel.

In the display panel of the present disclosure, in each of the pixel units, the minimum distance between the first sub-pixel and the third sub-pixel is greater than or equal to 15.9 microns, and the minimum distance between the second sub-pixel and the third sub-pixel is greater than or equal to 15.9 microns.

In the display panel of the present disclosure, the area of the first sub-pixel is less than the area of the second sub-pixel.

In the display panel of the present disclosure, a ratio of the area of the first sub-pixel, the area of the second sub-pixel and the area of the third sub-pixel is equal in each of the pixel units.

In the display panel of the present disclosure, the light-emitting repeating unit is disposed to be centrosymmetric with respect to the center point of the dummy rectangle, and the pixel units in same one of the light-emitting repeating unit are disposed to be centrosymmetric with respect to the center point of the dummy rectangle.

In the display panel of the present disclosure, each of the light-emitting repeating units comprises four pixel units,
four first sub-pixels close to the center point of the dummy rectangle, in the same one of the light-emitting repeating units, are disposed to be centrosymmetric with respect to the center point of the dummy rectangle,
four second sub-pixels close to the vertices of the dummy rectangle, in the same one of the light-emitting repeating units, are disposed to be centrosymmetric with respect to the center point of the dummy rectangle,
four third sub-pixels overlapping with the lines connecting the center point and the vertices of the dummy rectangle, in the same one of the light-emitting repeating units, are disposed to be centrosymmetric with respect to the center point of the dummy rectangle.

In the display panel of the present disclosure, in the light-emitting repeating unit and the light-emitting repeating units adjacent thereto, the second light-emitting layer overlaps with at least two second electrodes adjacent to each other.

In the display panel of the present disclosure, the light-emitting repeating unit and the light-emitting repeating unit adjacent thereto are arranged around one of the vertices of the dummy rectangle, and a plurality of the second sub-pixels are arranged around same one of the vertices,

Wherein, in the second sub-pixels arranged around the same one of the vertices, the second light-emitting layer overlaps with the second electrodes of at least two of the second sub-pixels.

In the display panel of the present disclosure, the second light-emitting layer overlaps with the second electrodes of all of the second sub-pixels arranged around the same one of the vertices.

In the display panel of the present disclosure, in two adjacent light-emitting repeating units, a distance between two adjacent second sub-pixels is greater than or equal to 2 microns.

In the display panel of the present disclosure, in two adjacent pixel units within same one of the light-emitting repeating units, a distance between two adjacent first sub-pixels is greater than or equal to 2 microns.

In the display panel of the present disclosure, in the same one of the light-emitting repeating units, the first light-emitting layer overlaps with the first electrodes of all of the first sub-pixels.

In the display panel of the present disclosure, the display panel further comprises:
support column disposed between third sub-pixels of two adjacent light-emitting repeating units, and the support column overlaps with side of corresponding dummy rectangle of the light-emitting repeating unit.

In the display panel of the present disclosure, the support column is located between the third sub-pixels adjacent thereto, and the support column does not overlap with the third sub-pixels adjacent thereto.

In the display panel of the present disclosure, the third sub-pixel has a centrosymmetric pattern, and
a center point of the third sub-pixel is located on a line connecting the center point of the dummy rectangle and the vertex of the dummy rectangle.

In the display panel of the present disclosure, the first sub-pixel and the second sub-pixel are both triangular,
a plurality of the first sub-pixels at a center of the dummy rectangle, in same one of the light-emitting repeating unit, are combined into a rectangle, and
a plurality of the second sub-pixels, in the light-emitting repeating units adjacent to each other, are combined into a rectangle.

In the display panel of the present disclosure, the first sub-pixel is a red sub-pixel, the second sub-pixel is a green sub-pixel, and the third sub-pixel is a blue sub-pixel.

### Advantageous Effects

The present disclosure provides a display panel, the display panel comprises first sub-pixels, second sub-pixels and third sub-pixels, the first sub-pixel comprises a first electrode and a first light-emitting layer disposed on the first electrode, the second sub-pixel comprises a second electrode and a second light-emitting layer disposed on the second electrode, the third sub-pixel comprises a third electrode and a third light-emitting layer disposed on the third electrode; this display panel further comprises a plurality of light-emitting repeating units, each of which comprises: a plurality of the first sub-pixels disposed at a center of a dummy rectangle, a plurality of the second sub-pixels disposed close to vertices of the dummy rectangle, a plurality of the third sub-pixels disposed between the first sub-pixel and the second sub-pixel which are adjacent to each other; wherein the first light-emitting layer overlaps with at least two of the first electrodes. In the present application, a plurality of the first sub-pixels are disposed at the center of one of the dummy rectangles, and the first light-emitting layer overlaps with at least two of the first electrodes, so that the light-emitting layers of the plurality of the first sub-pixels at the center of the dummy rectangle may be formed by using one opening of the mask, thereby improving the aperture ratio of the mask, reducing the difficulty of opening the mask, increasing the pixel density of the display panel, and improving the display effect.

### DESCRIPTION OF DRAWINGS

In order to more clearly explain the technical solutions in the embodiments or the prior art, the following will briefly introduce the drawings required in the description of the embodiments or the prior art. Obviously, the drawings in the following description are only some embodiments of the present disclosure. For those skilled in the art, without paying any creative work, other drawings can be obtained based on these drawings.
FIG. 1 is a schematic structural view of a partial cross-section of a display panel provided by an embodiment of the present disclosure.
FIG. 2 is a schematic structural view of a first type of pixel of a display panel provided by an embodiment of the present disclosure.
FIG. 3 is a schematic structural view of one light-emitting repeating unit in the pixel structure shown in FIG. 2.
FIG. 4 is a schematic structural view of a pixel unit in the light-emitting repeating unit shown in FIG. 3.
FIG. 5 is a schematic structural view of a second type of pixel of a display panel provided by an embodiment of the present disclosure.
FIG. 6 is a schematic structural view of one light-emitting repeating unit in the pixel structure shown in FIG. 5.
FIG. 7 is a schematic structural view of a pixel unit in the light-emitting repeating unit shown in FIG. 6.
FIG. 8 is a schematic structural view of a third type of pixel of a display panel provided by an embodiment of the present disclosure.
FIG. 9 is a schematic structural view of one light-emitting repeating unit in the pixel structure shown in FIG. 8.
FIG. 10 is a schematic structural view of a pixel unit in the light-emitting repeating unit shown in FIG. 9.
FIG. 11 is a schematic structural view of a fourth type of pixel of a display panel provided by an embodiment of the present disclosure.
FIG. 12 is a schematic structural view of one light-emitting repeating unit in the pixel structure shown in FIG. 11.
FIG. 13 is a schematic structural view of a pixel unit in the light-emitting repeating unit shown in FIG. 12.

### DETAILED DESCRIPTION OF EMBODIMENTS

The description of the following embodiments refers to the attached drawings to illustrate specific embodiments in which the present disclosure can be implemented. The directional terms mentioned in the present disclosure, such as [up], [down], [front], [back], [left], [right], [inner], [outer], [side], etc., are only the direction of the attached drawings. Therefore, the directional terms used are used to describe and understand the present disclosure, rather than to limit the present disclosure. In the drawings, units with similar structures are indicated by the same reference numerals.

The present disclosure provides a display panel, the display panel includes first sub-pixels, second sub-pixels, and third sub-pixels, the first sub-pixels include a first electrode and a first light-emitting layer disposed on the first electrode, the second sub-pixels include a second electrode and a second light-emitting layer disposed on the second electrode, the third sub-pixels include a third electrode and a third light-emitting layer disposed on the third electrode; the display panel further includes a plurality of light-emitting repeating units, and each of the light-emitting repeating units includes: a plurality of the first sub-pixels disposed at a center of a dummy rectangle, a plurality of the second sub-pixels disposed close to vertices of the dummy rectangle, a plurality of the third sub-pixels disposed between the first sub-pixel and the second sub-pixel which are adjacent to each other; wherein the first light-emitting layer overlaps with at least two of the first electrodes. In embodiments of the present application, a plurality of the first sub-pixels are disposed at the center of one of the dummy rectangles, and the first light-emitting layer overlaps with at least two of the first electrodes, so that the light-emitting layers of the plurality of the first sub-pixels at the center of the dummy rectangle may be formed by using one opening of a mask, thereby improving an aperture ratio of the mask, reducing difficulty of opening the mask, increasing a pixel density of the display panel and improving a display effect.

Structural features of a display panel provided by the present disclosure will be described below in conjunction with specific embodiments.

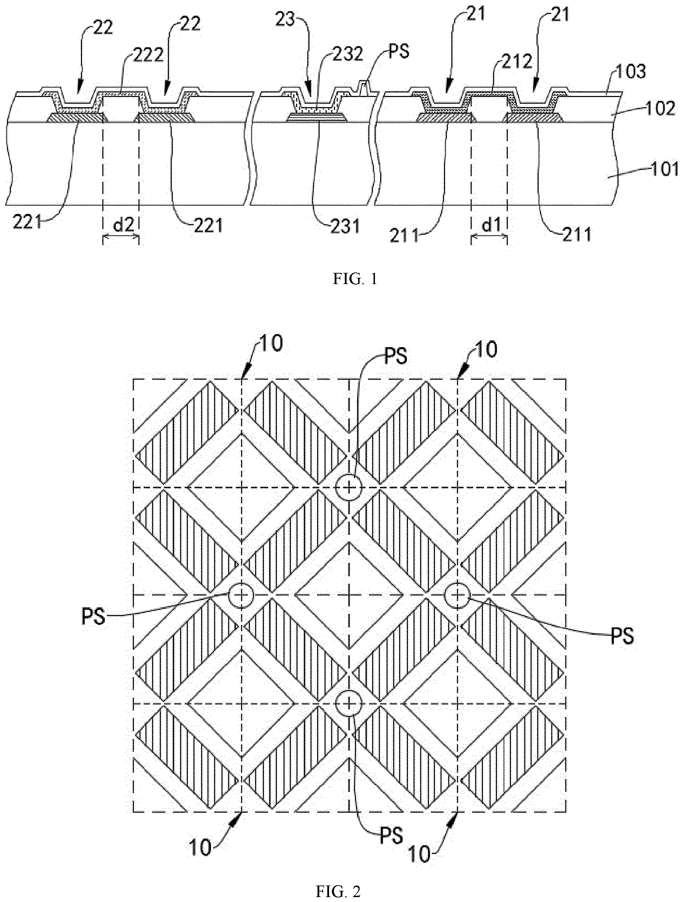

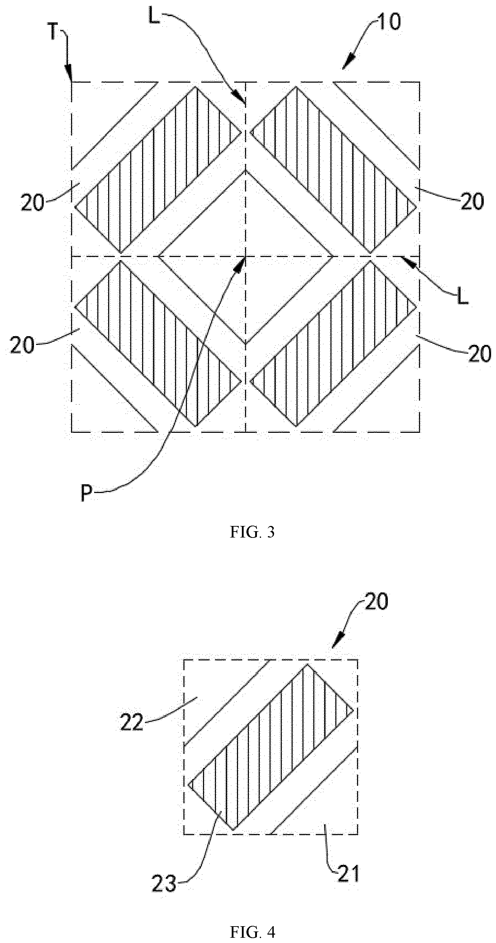

In one embodiment, as shown in FIGs. 1 to 4, FIG. 1 is a schematic structural view of a partial cross-section of a display panel provided by an embodiment of the present disclosure, FIG. 2 is a schematic structural view of a first type of pixel of the display panel provided by an embodiment of the present disclosure, FIG. 3 is a schematic structural view of one light-emitting repeating unit in the pixel structure shown in FIG. 2, and FIG. 4 is a schematic structural view of a pixel unit in the light-emitting repeating unit shown in FIG. 3.

The display panel includes: an array substrate 101 and a light-emitting device layer disposed on the array substrate 101, a driving circuit is disposed on the array substrate 101, the driving circuit is used to supply driving signals to respective light-emitting devices in the light-emitting device layer, and to control a light-emitting operation of the respective light-emitting devices.

Alternatively, the array substrate 101 includes: a substrate layer and a thin film transistor layer disposed on the substrate layer, wherein a plurality of scan lines, a plurality of data lines, a plurality of thin film transistors and the like required to form the driving circuit are disposed in the thin film transistor layer.

The light-emitting device layer includes: a pixel defining layer 102 disposed on the array substrate 101 and light-emitting devices disposed corresponding to respective openings of the pixel defining layer 102, each of the light-emitting devices corresponds to one sub-pixel on the display panel.

Specifically, the display panel includes: a plurality of first sub-pixels 21 displaying a first color, a plurality of second sub-pixels 22 displaying a second color, and a plurality of third sub-pixels 23 displaying a third color.

Alternatively, an area of a single first sub-pixel 21 and an area of a single second sub-pixel 22 are both less than an area of a single third sub-pixel 23.

The first sub-pixel 21 includes: a first electrode 211 disposed on the array substrate 101, and a first light-emitting layer 212 disposed on the first electrode 211, at least part of an area of the pixel defining layer 102; at least part of an area of the first light-emitting layer 212 is arranged corresponding to the opening of the pixel defining layer 102 and is in contact with the first electrode 211.

The second sub-pixel 22 includes: a second electrode 221 disposed on the array substrate 101, and a second light-emitting layer 222 disposed on the second electrode 221, at least part of an area of the second electrode 221 is exposed through the opening of the pixel defining layer 102; at least part of an area of the second light-emitting layer 222 is arranged corresponding to the opening of the pixel defining layer 102 and is in contact with the second electrode 221.

The third sub-pixel 23 includes: a third electrode 231 disposed on the array substrate 101, and a third light-emitting layer 232 disposed on the third electrode 231, at least part of an area of the third electrode 231 is exposed through the opening of the pixel defining layer 102; at least part of an area of the third light-emitting layer 232 is arranged corresponding to the opening of the pixel defining layer 102 and is in contact with the third electrode 231.

The display panel further includes a fourth electrode 103 disposed on the pixel defining layer 102, the fourth electrode 103 is in contact with the first light-emitting layer 212, the second light-emitting layer 222, and the third light-emitting layer 232.

Alternatively, the first electrode 211, the second electrode 221, and the third electrode 231 are all anodes, and they are maintained to be electrically insulated between one another; the fourth electrode 103 is a cathode; the first light-emitting layer 212, the second light-emitting layer 222, and the third light-emitting layer 232 are all light-emitting functional layers made of light-emitting functional materials.

Alternatively, the display panel further includes support columns PS disposed on the pixel defining layer 102, and the support columns PS are used to support the mask during forming of the first light-emitting layer 212, the second light-emitting layer 222, and the third light-emitting layer 232, and to maintain a certain gap between the mask and the display panel, so that the materials of the respective light-emitting layers are accurately deposited in the openings of the pixel defining layer 102 through an opening of the mask.

Further, the display panel includes a plurality of light-emitting repeating units 10, each of the light-emitting repeating units 10 includes: a plurality of the first sub-pixels 21, a plurality of the second sub-pixels 22, and a plurality of the third sub-pixels 23. Alternatively, the first sub-pixels 21 are red sub-pixels, the second sub-pixels 22 are green sub-pixels, and the third sub-pixels 23 are blue sub-pixels.

The first sub-pixels 21 and the second sub-pixels 22 are both triangular; the third sub-pixels 23 may be rectangular or other polygonal structures, and may also have circular or elliptical structures. It should be noted that the structures of the sub-pixels described in the embodiments of the present disclosure refers to a shape of each sub-pixel orthographically projected on a surface of the array substrate 101.

In a same one of the light-emitting repeating units 10, a plurality of the first sub-pixels 21 are disposed at a center point P of a dummy rectangle T, and the first light-emitting layer 212 overlaps with at least two of the first electrodes 211. In the present embodiment, two or more first sub-pixels 21 are disposed at the center point P of one of the dummy rectangles T, and the first light-emitting layer 212 overlaps with at least two of the first electrodes 211, so that the light-emitting layers of the plurality of the first sub-pixels 21 at the center of the dummy rectangle T may be formed by using one opening of the mask, thereby improving the aperture ratio of the mask, reducing the difficulty of opening the mask, increasing the pixel density of the display panel, and improving the display effect.

In a same one of the light-emitting repeating units 10, a plurality of the second sub-pixels 22 are disposed in a region of the dummy rectangle T and are close to vertices of the dummy rectangle T; a plurality of the third sub-pixels 23 are disposed between the first sub-pixels 21 and the second sub-pixels 22 which are adjacent to each other, respectively, and overlap with lines connecting the center and the vertices of the dummy rectangle T respectively. Each of the light-emitting repeating units 10 is disposed to be centrosymmetric with respect to the center point P of the dummy rectangle T corresponding to this light-emitting repeating unit 10; pixel units 20 in the same one of the light-emitting repeating units 10 are disposed to be centrosymmetric with respect to the center point P of the dummy rectangle T. A center point of the third sub-pixel 23 is located on the line connecting the center point P of the dummy rectangle T and the vertex of the dummy rectangle T.

Further, each of the light-emitting repeating units 10 includes a plurality of the pixel units 20, each of the pixel units 20 includes one first sub-pixel 21, one second sub-pixel 22, and one third sub-pixel 23. In same one of the light-emitting repeating units 10, the first sub-pixels 21 in two adjacent pixel units 20 are disposed adjacently, the first light-emitting layers 212 of the plurality of adjacent first sub-pixels 21 are connected to each other, and the first electrodes 211 of the plurality of adjacent first sub-pixels 21 are insulated from each other.

Alternatively, a ratio of the area of the first sub-pixel 21, the area of the second sub-pixel 22, and the area of the third sub-pixel 23 is equal in each of the pixel units 20. The area of the first sub-pixel 21 refers to the area of the first sub-pixel 21 orthographically projected on the surface of the array substrate 101, the area of the second sub-pixel 22 refers to the area of the second sub-pixel 22 orthographically projected on the surface of the array substrate 101, and the area of the third sub-pixel 23 refers to the area of the third sub-pixel 23 orthographically projected on the surface of the array substrate 101.

Further, the area of the first sub-pixel 21 is less than the area of the second sub-pixel 22, and the area of the first sub-pixel 21 and the area of the second sub-pixel 22 are both less than the area of the third sub-pixel 23.

Alternatively, in each of the light-emitting repeating units 10, a minimum distance between the first sub-pixel 21 and the third sub-pixel 23 remains unchanged; a minimum distance between the second sub-pixel 22 and the third sub-pixel 23 remains unchanged. Through an above arrangement of the present embodiment, a purpose of simplifying structure complexity of the mask for forming each of the sub-pixels is achieved, thereby reducing cost of production.

Further, in each of the pixel units 20, the minimum distance between the first sub-pixel 21 and the third sub-pixel 23 is equal to the minimum distance between the second sub-pixel 22 and the third sub-pixel 23. The present embodiment further simplifies the structure complexity of the mask for forming each of the sub-pixels.

Further, in each of the pixel units 20, the minimum distance between the first sub-pixel 21 and the third sub-pixel 23 is greater than or equal to 15.9 microns, preferably 15.9 microns; the minimum distance between the second sub-pixel 22 and the third sub-pixel 23 is greater than or equal to 15.9 microns, preferably 15.9 microns. In the present embodiment, when the distance between the first sub-pixel 21 and the third sub-pixel 23 attains a minimum value and the distance between the second sub-pixel 22 and the third sub-pixel 23 attains a minimum value, the sum of the area of the first sub-pixel 21, the area of the second sub-pixel 22, and the area of the third sub-pixel 23 attains a maximum value, so that the sum of the areas of the sub-pixels in the display panel attains a maximum value, thereby improving the display effect of the display panel.

Alternatively, each of the light-emitting repeating units 10 includes four pixel units 20, and on this basis, each of the light-emitting repeating units 10 includes four first sub-pixels 21, four second sub-pixels 22, and four third sub-pixels 23. In a same one of the light-emitting repeating units 10, the four first sub-pixels 21 are disposed adjacently, and are all arranged at the center point P of the dummy rectangle T, the first light-emitting layers 212 of the four first sub-pixels 21 are connected to each other, and the first electrodes 211 of the four fist sub-pixels 21 are insulated from each other.

In a same one of the light-emitting repeating units 10, the four first sub-pixels 21 close to the center point P of the dummy rectangle T are disposed to be centrosymmetric with respect to the center point P of the dummy rectangle T; in the same one of the light-emitting repeating units 10, the four second sub-pixels 22 close to the vertices of the dummy rectangle T are disposed to be centrosymmetric with respect to the center point P of the dummy rectangle T; in the same one of the light-emitting repeating units 10, the four third sub-pixels 23 disposed overlapping the lines connecting the center point P and the vertices of the dummy rectangle T are disposed to be centrosymmetric with respect to the center point P of the dummy rectangle T.

Further, in two adjacent pixel units 20 within the same one of the light-emitting repeating units 10, a distance d1 between two adjacent first sub-pixels 21 is greater than or equal to 2 microns.

Further, a line connecting midpoints of opposite sides of the dummy rectangle T is referred to as a center line L. In the same one of the light-emitting repeating units 10, the two adjacent pixel units 20 are symmetrical about the center line L, and the respective sub-pixels in the two adj acent pixel units 20 are symmetrical about the center line L respectively.

Alternatively, in the light-emitting repeating unit 10 and the light-emitting repeating unit 10 adjacent thereto, there are at least two second sub-pixels 22 disposed adjacently, and the second light-emitting layer 222 overlaps with at least two adjacent second electrodes 221. In the present embodiment, two or more second sub-pixels 22 are disposed adjacently, and the second light-emitting layer 222 overlaps with the at least two second electrodes 221, so that the light-emitting layers of the plurality of adjacent second sub-pixels 22 may be formed by using one opening of the mask, thereby further improving the aperture ratio of the mask and increasing the pixel density of the display panel.

Further, the light-emitting repeating unit 10 and the light-emitting repeating unit 10 adjacent thereto are arranged around one of the vertices of the dummy rectangle T, a plurality of the second sub-pixels 22 are arranged around same one of the vertices, in the second sub-pixels 22 arranged around the same one of the vertices, the second light-emitting layer 222 overlaps with the second electrodes 221 of the at least two second sub-pixels 22.

Further, in two adjacent light-emitting repeating units 10, a distance d2 between two adjacent second sub-pixels 22 is greater than or equal to 2 microns.

Further, in the same one of the light-emitting repeating units 10, the four first sub-pixels 21 at the center of the dummy rectangle T are combined into a rectangle, and the first light-emitting layer 212 overlaps with the first electrodes 211 of all the first sub-pixels 21.

In four adjacent light-emitting repeating units 10, four second sub-pixels 22 are combined into a rectangle, and the second light-emitting layer 222 overlaps with the second electrodes 221 of all the second sub-pixels 22.

Further, the support column PS is disposed between the third sub-pixels 23 of two adjacent light-emitting repeating units 10, and the support column PS overlaps with a side line of the dummy rectangle T corresponding to the light-emitting repeating unit 10. The support column PS does not overlap with the third sub-pixels 23, to wit, an orthographic projection of the support column PS on the surface of the array substrate 101 does not overlap with the orthographic projection of the third sub-pixel 23 on the surface of the array substrate 101.

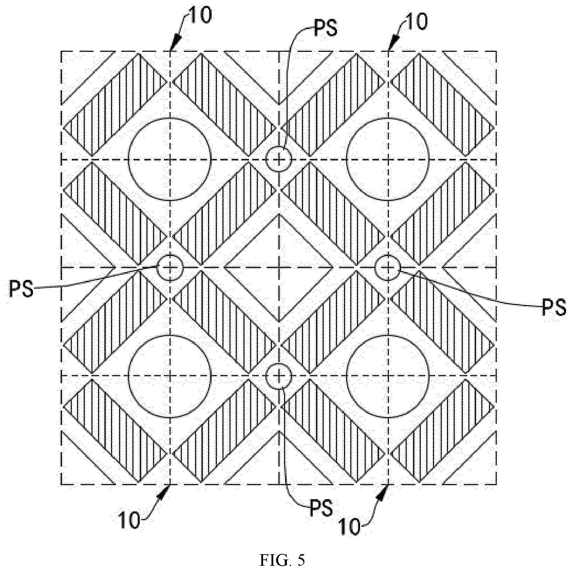

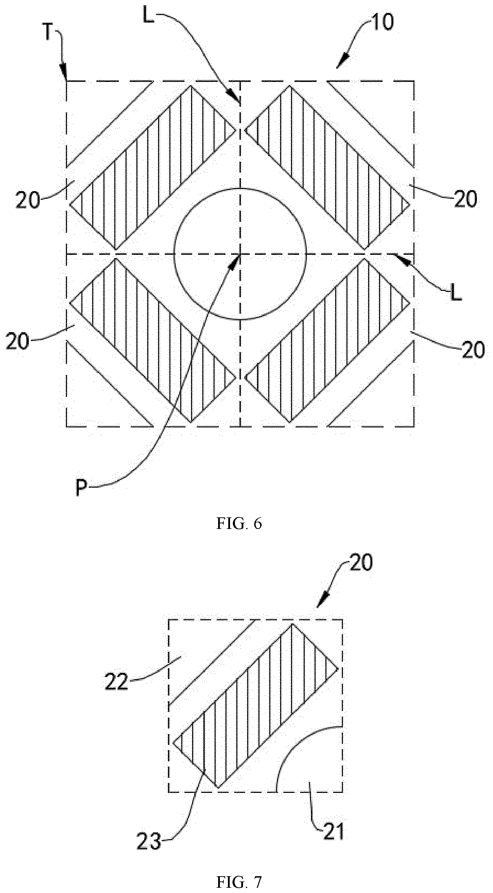

In another embodiment, as shown in FIGs. 1 and 5 to 7, FIG. 5 is a schematic structural view of a second type of pixel of the display panel provided by an embodiment of the present disclosure, FIG. 6 is a schematic structural view of one light-emitting repeating unit in the pixel structure shown in FIG. 5, and FIG. 7 is a schematic structural view of a pixel unit in the light-emitting repeating unit shown in FIG. 6. It should be noted that the display panel provided by the present embodiment has a same structure as or a similar structure to a structure of the display panel provided in the above embodiment, and a difference therebetween lies only in that the structures of some sub-pixels are different from each other. Structural features of the display panel provided in the present embodiment will be described below, the parts that are not described in detail may refer to a record of the above embodiments.

The display panel includes a plurality of the light emitting repeating units 10, each of the light-emitting repeating units 10 includes a plurality of the first sub-pixels 21, a plurality of the second sub-pixels 22, and a plurality of the third sub-pixels 23. The first sub-pixel 21 may be a red sub-pixel, the second sub-pixel 22 may be a green sub-pixel, and the third sub-pixel 23 may be a blue sub-pixel.

The first sub-pixel 21 has a structure of a quarter circle, the second sub-pixel 22 has a triangular structure, and the third sub-pixel 23 may have a rectangular or other polygonal structure, or a circular or elliptical structure.

In a same one of the light-emitting repeating units 10, a plurality of the first sub-pixels 21 are disposed at a center point P of a dummy rectangle T, and a first light-emitting layer 212 overlaps with at least two first electrodes 211. A plurality of the second sub-pixels 22 are disposed in a region of the dummy rectangle T and are close to vertices of the dummy rectangle T; a plurality of the third sub-pixels 23 are disposed between the first sub-pixels 21 and the second sub-pixels 22 which are adjacent to each other, respectively, and overlap with lines connecting the center point P and the vertices of the dummy rectangle T respectively.

Each of the light-emitting repeating units 10 is disposed to be centrosymmetric with respect to the center point P of the dummy rectangle T corresponding to this light-emitting repeating unit 10; pixel units 20 in a same one of the light-emitting repeating units 10 are disposed to be centrosymmetric with respect to the center point P of the dummy rectangle T. A line connecting midpoints of two opposite sides of the dummy rectangle T is a center line L, in a same one of the light-emitting repeating units 10, two adjacent pixel units 20 are symmetrical about the center line L, and respective sub-pixels in the two adjacent pixel units 20 are symmetrical about the center line L respectively. A center point of the third sub-pixel 23 is located on the line connecting the center point P of the dummy rectangle T and the vertex of the dummy rectangle T.

Each of the light-emitting repeating units 10 includes a plurality of the pixel units 20, and each of the pixel units 20 includes one first sub-pixel 21, one second sub-pixel 22, and one third sub-pixel 23. In a same one of the light-emitting repeating units 10, the first sub-pixels 21 in two adjacent pixel units 20 are disposed adjacently, first light-emitting layers 212 of a plurality of adjacent first sub-pixels 21 are connected to each other, and the first electrodes 211 of the plurality of adj acent first sub-pixels 21 are insulated from each other.

Alternatively, a ratio of the area of the first sub-pixel 21, the area of the second sub-pixel 22, and the area of the third sub-pixel 23 is equal in each of the pixel units 20.

Further, the area of the first sub-pixel 21 is less than the area of the second sub-pixel 22, and the area of the first sub-pixel 21 and the area of the second sub-pixel 22 are both less than the area of the third sub-pixel 23.

Alternatively, in each of the light-emitting repeating units 10, a minimum distance between the first sub-pixel 21 and the third sub-pixel 23 remains unchanged; a minimum distance between the second sub-pixel 22 and the third sub-pixel 23 remains unchanged. In each of the pixel units 20, the minimum distance between the first sub-pixel 21 and the third sub-pixel 23 is equal to the minimum distance between the second sub-pixel 22 and the third sub-pixel 23.

Further, in each of the pixel units 20, the minimum distance between the first sub-pixel 21 and the third sub-pixel 23 is greater than or equal to 15.9 microns, preferably 15.9 microns; the minimum distance between the second sub-pixel 22 and the third sub-pixel 23 is greater than or equal to 15.9 microns, preferably 15.9 microns.

Alternatively, each of the light-emitting repeating units 10 includes four pixel units 20, and on this basis, each of the light-emitting repeating units 10 includes four first sub-pixels 21, four second sub-pixels 22, and four third sub-pixels 23. In a same one of the light-emitting repeating units 10, the four first sub-pixels 21 are disposed adjacently, and are all arranged at the center point P of the dummy rectangle T, the first light-emitting layers 212 of the four first sub-pixels 21 are connected to each other, and the first electrodes 211 of the four fist sub-pixels 21 are insulated from each other.

In a same one of the light-emitting repeating units 10, the four first sub-pixels 21 close to the center point P of the dummy rectangle T are disposed to be centrosymmetric with respect to the center point P of the dummy rectangle T; in the same one of the light-emitting repeating units 10, the four second sub-pixels 22 close to the vertices of the dummy rectangle T are disposed to be centrosymmetric with respect to the center point P of the dummy rectangle T; in the same one of the light-emitting repeating units 10, the four third sub-pixels 23 disposed overlapping the lines connecting the center point P and the vertices of the dummy rectangle T are disposed to be centrosymmetric with respect to the center point P of the dummy rectangle T.

In two adjacent pixel units 20 within a same one of the light-emitting repeating units 10, a distance d1 between two adjacent first sub-pixels 21 is greater than or equal to 2 microns.

Alternatively, in the light-emitting repeating unit 10 and the light-emitting repeating units 10 adjacent thereto, there are at least two second sub-pixels 22 disposed adjacently, and the second light-emitting layer 222 overlaps with at least two adjacent second electrodes 221. In two adjacent light-emitting repeating units 10, a distance d2 between two adjacent second sub-pixels 22 is greater than or equal to 2 microns.

Further, the four first sub-pixels 21 at the center of the dummy rectangle T are combined into a circular structure; and in four adjacent light-emitting repeating units 10, four second sub-pixels 22 are combined into a rectangle.

Further, the support column PS is disposed between the third sub-pixels 23 of two adjacent light-emitting repeating units 10, and the support column PS overlaps with a side line of the dummy rectangle T corresponding to the light-emitting repeating unit 10. The support column PS does not overlap with the third sub-pixels 23.

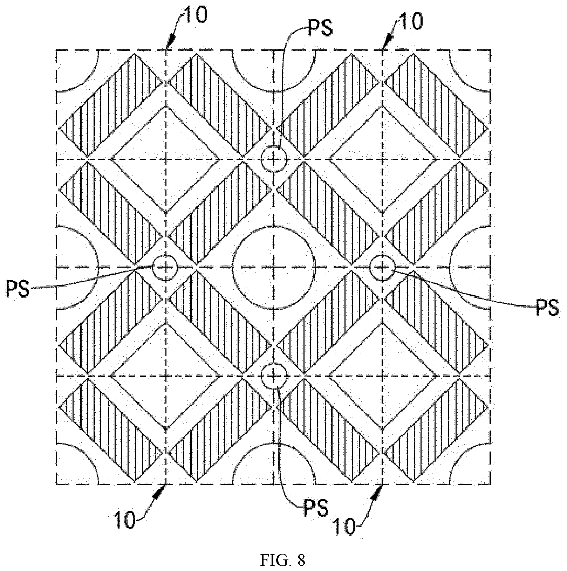

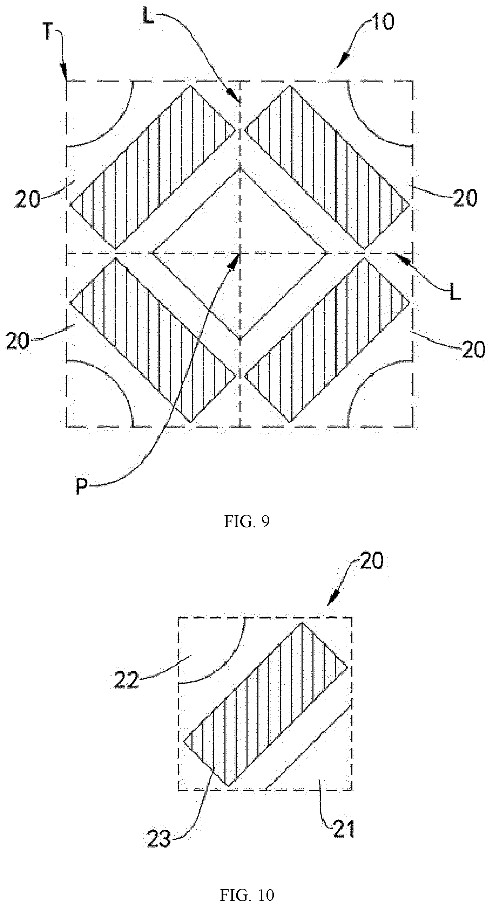

In still another embodiment, as shown in FIGs. 1 and 8 to 10, FIG. 8 is a schematic structural view of a third type of pixel of a display panel provided by an embodiment of the present disclosure, FIG. 9 is a schematic structural view of one light-emitting repeating unit in the pixel structure shown in FIG. 8, and FIG. 10 is a schematic structural view of a pixel unit in the light-emitting repeating unit shown in FIG. 9. It should be noted that the display panel provided by the present embodiment has the same structure as or similar structure to the structure of the display panel provided in the above embodiment, and a difference therebetween lies only in that the structures of some sub-pixels are different from each other. Structural features of the display panel provided in the present embodiment will be described below, the parts that are not described in detail may refer to the record of the above embodiments.

The display panel includes a plurality of the light emitting repeating units 10, each of the light emitting repeating units 10 includes a plurality of the first sub-pixels 21, a plurality of the second sub-pixels 22 and a plurality of the third sub-pixels 23. The first sub-pixel 21 may be a red sub-pixel, the second sub-pixel 22 may be a green sub-pixel, and the third sub-pixel 23 may be a blue sub-pixel.

The first sub-pixel 21 has a triangular structure, the second sub-pixel 22 has a structure of quarter circle, and the third sub-pixel 23 may have a rectangular or other polygonal structure, or a circular or elliptical structure.

In the same one of the light-emitting repeating units 10, a plurality of the first sub-pixels 21 are disposed at a center point P of a dummy rectangle T, and the first light-emitting layer 212 overlaps with at least two first electrodes 211. A plurality of the second sub-pixels 22 are disposed in a region of the dummy rectangle T and are close to vertices of the dummy rectangle T; a plurality of the third sub-pixels 23 are disposed between the first sub-pixels 21 and the second sub-pixels 22 which are adjacent to each other, respectively, and overlap with the lines connecting the center point P and vertices of the dummy rectangle T respectively.

Each of the light-emitting repeating units 10 is disposed to be centrosymmetric with respect to the center point P of the dummy rectangle T corresponding to this light-emitting repeating unit 10; pixel units 20 in the same one of the light-emitting repeating units 10 are disposed to be centrosymmetric with respect to the center point P of the dummy rectangle T. A line connecting midpoints of two opposite sides of the dummy rectangle T is a center line L, in the same one of the light-emitting repeating units 10, the two adjacent pixel units 20 are symmetrical about the center line L, and the respective sub-pixels in the two adjacent pixel units 20 are symmetrical about the center line L respectively. A center point of the third sub-pixel 23 is located on the line connecting the center point P of the dummy rectangle T and the vertex of the dummy rectangle T.

Each of the light-emitting repeating units 10 includes a plurality of pixel units 20, and each of the pixel units 20 includes one first sub-pixel 21, one second sub-pixel 22 and one third sub-pixel 23. In same one of the light-emitting repeating units 10, the first sub-pixels 21 in two adjacent pixel units 20 are disposed adjacently, the first light-emitting layers 212 of the plurality of adjacent first sub-pixels 21 are connected to each other, and the first electrodes 211 of the plurality of adjacent first sub-pixels 21 are insulated from each other.

Alternatively, the ratio of the area of the first sub-pixel 21, the area of the second sub-pixel 22, and the area of the third sub-pixel 23 is equal in each of the pixel units 20.

Further, the area of the first sub-pixel 21 is less than the area of the second sub-pixel 22, and the area of the first sub-pixel 21 and the area of the second sub-pixel 22 are both less than the area of the third sub-pixel 23.

Alternatively, in each of the light-emitting repeating units 10, a minimum distance between the first sub-pixel 21 and the third sub-pixel 23 remains unchanged; a minimum distance between the second sub-pixel 22 and the third sub-pixel 23 remains unchanged. In each of the pixel units 20, the minimum distance between the first sub-pixel 21 and the third sub-pixel 23 is equal to the minimum distance between the second sub-pixel 22 and the third sub-pixel 23.

Further, in each of the pixel units 20, the minimum distance between the first sub-pixel 21 and the third sub-pixel 23 is greater than or equal to 15.9 microns, preferably 15.9 microns; the minimum distance between the second sub-pixel 22 and the third sub-pixel 23 is greater than or equal to 15.9 microns, preferably 15.9 microns.

Alternatively, each of the light-emitting repeating units 10 includes four pixel units 20, and on this basis, each of the light-emitting repeating units 10 includes four first sub-pixels 21, four second sub-pixels 22 and four third sub-pixels 23.

In the same one of the light-emitting repeating units 10, the four first sub-pixels 21 close to the center point P of the dummy rectangle T are disposed to be centrosymmetric with respect to the center point P of the dummy rectangle T; in the same one of the light-emitting repeating units 10, the four second sub-pixels 22 close to the vertices of the dummy rectangle T are disposed to be centrosymmetric with respect to the center point P of the dummy rectangle T; in the same one of the light-emitting repeating units 10, the four third sub-pixels 23 disposed overlapping the lines connecting the center point P and the vertices of the dummy rectangle T are disposed to be centrosymmetric with respect to the center point P of the dummy rectangle T.

In two adjacent pixel units 20 within the same one of the light-emitting repeating units 10, a distance d1 between two adjacent first sub-pixels 21 is greater than or equal to 2 microns.

Alternatively, in the light-emitting repeating unit 10 and the light-emitting repeating units 10 adjacent thereto, there are at least two second sub-pixels 22 disposed adjacently, and the second light-emitting layer 222 overlaps with at least two adjacent second electrodes 221. In two adjacent light-emitting repeating units 10, a distance d2 between two adjacent second sub-pixels 22 is greater than or equal to 2 microns.

Further, the four first sub-pixels 21 at the center of the dummy rectangle T are combined into a rectangle; and in four adjacent light-emitting repeating units 10, four second sub-pixels 22 are combined into a circular structure.

Further, the support column PS is disposed between the third sub-pixels 23 of two adjacent light-emitting repeating units 10, and the support column PS overlaps with side of dummy rectangle T corresponding to the light-emitting repeating unit 10. The support column PS does not overlap with the third sub-pixels 23.

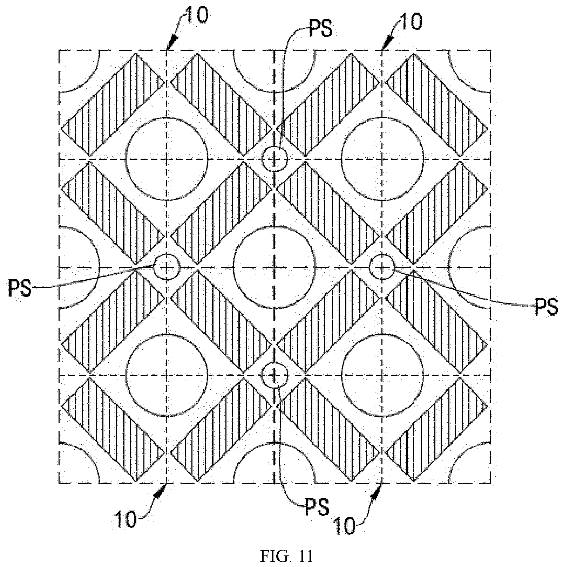

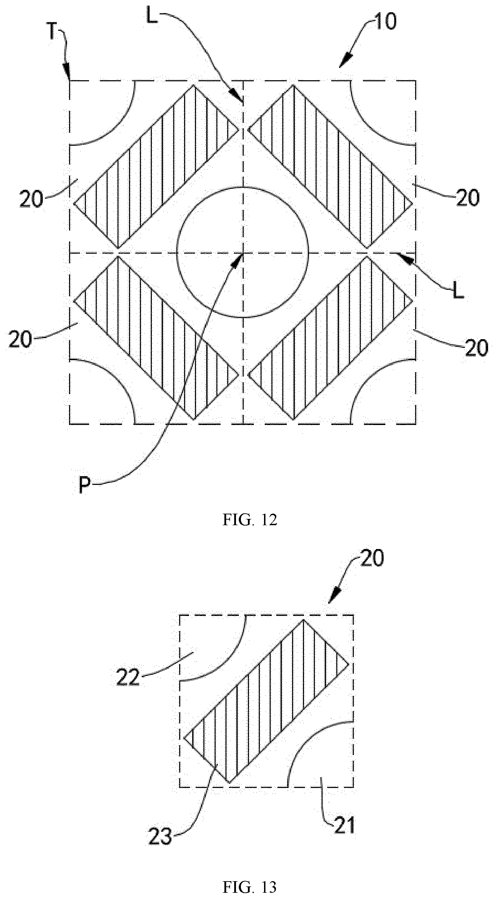

In another embodiment, as shown in FIGs. 1 and 11 to 13, FIG. 11 is a schematic structural view of a fourth type of pixel of a display panel provided by an embodiment of the present disclosure, FIG. 12 is a schematic structural view of one light-emitting repeating unit in the pixel structure shown in FIG. 11, and FIG. 13 is a schematic structural view of a pixel unit in the light-emitting repeating unit shown in FIG. 12. It should be noted that the display panel provided by the present embodiment has the same structure as or similar structure to the structure of the display panel provided in the above embodiment, and the difference therebetween lies only in that the structures of some sub-pixels are different from each other. The structural features of the display panel provided in the present embodiment will be described below, the parts that are not described in detail may refer to the record of the above embodiments.

The display panel includes a plurality of the light emitting repeating units 10, each of which includes a plurality of the first sub-pixels 21, a plurality of the second sub-pixels 22 and a plurality of the third sub-pixels 23. The first sub-pixel 21 may be a red sub-pixel, the second sub-pixel 22 may be a green sub-pixel, and the third sub-pixel 23 may be a blue sub-pixel.

Both the first sub-pixel 21 and the second sub-pixel 22 have a structure of quarter circle, and the third sub-pixel 23 may have a rectangular or other polygonal structure, or a circular or elliptical structure.

In the same one of the light-emitting repeating units 10, a plurality of the first sub-pixels 21 are disposed at a center point P of a dummy rectangle T, and the first light-emitting layer 212 overlaps with at least two first electrodes 211. A plurality of the second sub-pixels 22 are disposed in a region of the dummy rectangle T and are close to vertices of the dummy rectangle T; a plurality of the third sub-pixels 23 are disposed between the first sub-pixel 21 and the second sub-pixel 22 which are adjacent to each other, respectively, and overlap with lines connecting the center point P and vertices of the dummy rectangle T respectively.

Each of the light-emitting repeating units 10 is disposed to be centrosymmetric with respect to the center point P of the dummy rectangle T corresponding to this light-emitting repeating unit 10; pixel units 20 in the same one of the light-emitting repeating units 10 are disposed to be centrosymmetric with respect to the center point P of the dummy rectangle T. A line connecting midpoints of two opposite sides of the dummy rectangle T is a center line L, in the same one of the light-emitting repeating units 10, the two adjacent pixel units 20 are symmetrical about the center line L, and the respective sub-pixels in the two adjacent pixel units 20 are symmetrical about the center line L respectively. A center point of the third sub-pixel 23 is located on the line connecting the center point P of the dummy rectangle T and the vertex of the dummy rectangle T.

Each of the light-emitting repeating units 10 includes a plurality of pixel units 20, and each of the pixel units 20 includes one first sub-pixel 21, one second sub-pixel 22 and one third sub-pixel 23. In same one of the light-emitting repeating units 10, the first sub-pixels 21 in two adjacent pixel units 20 are disposed adjacently, the first light-emitting layers 212 of the plurality of adjacent first sub-pixels 21 are connected to each other, and the first electrodes 211 of the plurality of adjacent first sub-pixels 21 are insulated from each other.

The ratio of the area of the first sub-pixel 21, the area of the second sub-pixel 22, and the area of the third sub-pixel 23 is equal in each of the pixel units 20.

Alternatively, the area of the first sub-pixel 21 is less than the area of the second sub-pixel 22, and the area of the first sub-pixel 21 and the area of the second sub-pixel 22 are both less than the area of the third sub-pixel 23.

Alternatively, in each of the light-emitting repeating units 10, a minimum distance between the first sub-pixel 21 and the third sub-pixel 23 remains unchanged; a minimum distance between the second sub-pixel 22 and the third sub-pixel 23 remains unchanged. In each of the pixel units 20, the minimum distance between the first sub-pixel 21 and the third sub-pixel 23 is equal to the minimum distance between the second sub-pixel 22 and the third sub-pixel 23.

Further, in each of the pixel units 20, the minimum distance between the first sub-pixel 21 and the third sub-pixel 23 is greater than or equal to 15.9 microns, preferably 15.9 microns; the minimum distance between the second sub-pixel 22 and the third sub-pixel 23 is greater than or equal to 15.9 microns, preferably 15.9 microns.

Alternatively, in each of the pixel units 20, a minimum distance from an edge of the third sub-pixel 23 to an edge of the first sub-pixel 21 is equal to a minimum distance from an edge of the third sub-pixel 23 to an edge of the second sub-pixel 22.

Alternatively, each of the light-emitting repeating units 10 includes four pixel units 20, and on this basis, each of the light-emitting repeating units 10 includes four first sub-pixels 21, four second sub-pixels 22 and four third sub-pixels 23.

In the same one of the light-emitting repeating units 10, the four first sub-pixels 21 close to the center point P of the dummy rectangle T are disposed to be centrosymmetric with respect to the center point P of the dummy rectangle T; in the same one of the light-emitting repeating units 10, the four second sub-pixels 22 close to the vertices of the dummy rectangle T are disposed to be centrosymmetric with respect to the center point P of the dummy rectangle T; in the same one of the light-emitting repeating units 10, the four third sub-pixels 23 disposed overlapping the lines connecting the center point P and the vertices of the dummy rectangle T are disposed to be centrosymmetric with respect to the center point P of the dummy rectangle T.

In two adjacent pixel units 20 within the same one of the light-emitting repeating units 10, a distance d1 between two adjacent first sub-pixels 21 is greater than or equal to 2 microns.

Alternatively, in the light-emitting repeating unit 10 and the light-emitting repeating units 10 adjacent thereto, there are at least two second sub-pixels 22 disposed adjacently, and the second light-emitting layer 222 overlaps with at least two adjacent second electrodes 221. In two adjacent light-emitting repeating units 10, a distance d2 between two adjacent second sub-pixels 22 is greater than or equal to 2 microns.

Further, the four first sub-pixels 21 at the center of the dummy rectangle T are combined into a circular structure; and in four adjacent light-emitting repeating units 10, four second sub-pixels 22 are combined into a circular structure.

Further, the support column PS is disposed between the third sub-pixels 23 of two adjacent light-emitting repeating units 10, and the support column PS overlaps with side of dummy rectangle T corresponding to the light-emitting repeating unit 10. The support column PS does not overlap with the third sub-pixels 23.

In summary, the display panel provided by the present disclosure includes first sub-pixels, second sub-pixels, and third sub-pixels, each first sub-pixel includes a first electrode and a first light-emitting layer disposed on the first electrode, each second sub-pixel includes a second electrode and a second light-emitting layer disposed on the second electrode, each third sub-pixel includes a third electrode and a third light-emitting layer disposed on the third electrode; this display panel further includes a plurality of light-emitting repeating units, each of the light-emitting repeating units includes: a plurality of the first sub-pixels disposed at a center of a dummy rectangle, a plurality of the second sub-pixels disposed close to vertices of the dummy rectangle, a plurality of the third sub-pixels disposed between the first sub-pixels and the second sub-pixels which are adjacent to each other; wherein the first light-emitting layer overlaps with at least two of the first electrodes. In embodiments of the present application, a plurality of the first sub-pixels are disposed at the center of one of the dummy rectangles, and the first light-emitting layer overlaps with at least two of the first electrodes, so that the light-emitting layers of the plurality of the first sub-pixels at the center of the dummy rectangle may be formed by using one opening of a mask, thereby improving an aperture ratio of the mask and increasing a pixel density of the display panel.

Further, in the present embodiment, two or more second sub-pixels are disposed adjacently, and the second light-emitting layer overlaps with the at least two second electrodes, so that the light-emitting layers of the plurality of adjacent second sub-pixels may be formed by using one opening of the mask, thereby further improving the aperture ratio of the mask and increasing the pixel density of the display panel.

In summary, although embodiments have been described above in the present disclosure, the above-mentioned embodiments are not intended to limit the present disclosure. Those of ordinary skilled in the art can make various modifications and changes without departing from the spirit and scope of the present disclosure. Therefore, the protection scope of the present disclosure is subject to the scope defined by the claims.

## Claims

1. A display panel, comprising:
a plurality of first sub-pixels displaying a first color, wherein each of the first sub-pixels comprises a first electrode and a first light-emitting layer disposed on the first electrode;
a plurality of second sub-pixels displaying a second color, wherein each of the second sub-pixels comprises a second electrode and a second light-emitting layer disposed on the second electrode; and
a plurality of third sub-pixels displaying a third color, wherein each of the third sub-pixels comprises a third electrode and a third light-emitting layer disposed on the third electrode,
wherein the display panel further comprises a plurality of light-emitting repeating units, each of the plurality of light-emitting repeating units comprises:
the plurality of first sub-pixels disposed close to a center point of a dummy rectangle, wherein the first light-emitting layer overlaps with at least two of the first electrodes;
the plurality of second sub-pixels disposed inside a region of the dummy rectangle and close to vertices of the dummy rectangle; and
the plurality of third sub-pixels disposed between the first sub-pixels and the second sub-pixels which are adjacent to each other, and overlapping with lines connecting the center point and the vertices of the dummy rectangle, wherein
an area of each of the first sub-pixels and an area of each of the second sub-pixels are both less than an area of each of the third sub-pixels.

2. The display panel of claim 1, wherein each of the light-emitting repeating units comprises a plurality of pixel units, each of the plurality of pixel units comprises one first sub-pixel, one second sub-pixel, and one third sub-pixel.

3. The display panel of claim 2, wherein, in each of the light-emitting repeating units, a minimum distance between the first sub-pixel and the third sub-pixel remains unchanged, and
a minimum distance between the second sub-pixel and the third sub-pixel remains unchanged.

4. The display panel of claim 3, wherein, in each of the pixel units, the minimum distance between the first sub-pixel and the third sub-pixel is equal to the minimum distance between the second sub-pixel and the third sub-pixel.

5. The display panel of claim 3, wherein, in each of the pixel units, the minimum distance between the first sub-pixel and the third sub-pixel is greater than or equal to 15.9 microns, and the minimum distance between the second sub-pixel and the third sub-pixel is greater than or equal to 15.9 microns.

6. The display panel of claim 2, wherein the area of the first sub-pixel is less than the area of the second sub-pixel.

7. The display panel of claim 6, wherein a ratio of the area of the first sub-pixel, the area of the second sub-pixel, and the area of the third sub-pixel is equal in each of the pixel units.

8. The display panel of claim 2, wherein each of the light-emitting repeating unit is disposed to be centrosymmetric with respect to the center point of the dummy rectangle, and the pixel units in a same one of the light-emitting repeating units are disposed to be centrosymmetric with respect to the center point of the dummy rectangle.

9. The display panel of claim 8, wherein each of the light-emitting repeating units comprises four pixel units,
four first sub-pixels close to the center point of the dummy rectangle in a same one of the light-emitting repeating units are disposed to be centrosymmetric with respect to the center point of the dummy rectangle,
four second sub-pixels close to the vertices of the dummy rectangle in a same one of the light-emitting repeating units are disposed to be centrosymmetric with respect to the center point of the dummy rectangle, and
four third sub-pixels overlapping with the lines connecting the center point and the vertices of the dummy rectangle in a same one of the light-emitting repeating units are disposed to be centrosymmetric with respect to the center point of the dummy rectangle.

10. The display panel of claim 1, wherein, in the light-emitting repeating units and light-emitting repeating units adjacent thereto, the second light-emitting layer overlaps with at least two second electrodes adjacent to each other.

11. The display panel of claim 10, wherein the light-emitting repeating unit and the light-emitting repeating units adjacent thereto are arranged around one of the vertices of the dummy rectangle, and a plurality of the second sub-pixels are arranged around same one of the vertices,
wherein, in the second sub-pixels arranged around a same one of the vertices, the second light-emitting layer overlaps with the second electrodes of at least two of the second sub-pixels.

12. The display panel of claim 11, wherein the second light-emitting layer overlaps with the second electrodes of all of the second sub-pixels arranged around a same one of the vertices.

13. The display panel of claim 10, wherein, in two adjacent light-emitting repeating units, a distance between two adjacent second sub-pixels is greater than or equal to 2 microns.

14. The display panel of claim 2, wherein, in two adjacent pixel units within a same one of the light-emitting repeating units, a distance between two adjacent first sub-pixels is greater than or equal to 2 microns.

15. The display panel of claim 14, wherein, in a same one of the light-emitting repeating units, the first light-emitting layer overlaps with the first electrodes of all of the first sub-pixels.

16. The display panel of claim 1, wherein the display panel further comprises a support column disposed between the third sub-pixels of two adjacent light-emitting repeating units, and the support column overlaps with a side line of the dummy rectangle corresponding to the light-emitting repeating unit.

17. The display panel of claim 16, wherein the support column is located between the third sub-pixels adjacent to the support column, and the support column does not overlap with the third sub-pixels adjacent to the support column.

18. The display panel of claim 1, wherein the third sub-pixel has a centrosymmetric pattern, and
a center point of the third sub-pixel is located on one of the lines connecting the center point of the dummy rectangle and the vertices of the dummy rectangle.

19. The display panel of claim 18, wherein the first sub-pixels and the second sub-pixels are both triangular,
a plurality of the first sub-pixels at a center of the dummy rectangle in a same one of the light-emitting repeating units are combined into a rectangle, and
a plurality of the second sub-pixels in the light-emitting repeating units adjacent to each other are combined into a rectangle.

20. The display panel of claim 1, wherein each of the first sub-pixel is a red sub-pixel, each of the second sub-pixel is a green sub-pixel, and each of the third sub-pixel is a blue sub-pixel.
